# EUROPEAN PATENT SPECIFICATION

(11) **EP 2 070 016 B1**
(45) Date of publication and mention of the grant of the patent: **19.01.2011**
(21) Application number: 07820048.2
(22) Date of filing: 06.09.2007
(51) Int. Cl.: G06K 19/07, G06K 19/077, H01L 23/48, H01F 41/04

(54) **METHOD OF CONNECTING AN ANTENNA TO A TRANSPONDER CHIP AND CORRESPONDING INLAY SUBSTRATE**
VERFAHREN FÜR DEN ANSCHLUSS EINER ANTENNE AN EINEN TRANSPONDERCHIP UND ENTSPRECHENDES EINLAGENSUBSTRAT
PROCÉDÉ DE CONNEXION D'UNE ANTENNE À UNE PUCE DE TRANSPONDEUR ET SUBSTRAT INCRUSTÉ CORRESPONDANT

(30) Priority: 26.09.2006 US 826923 P; 01.01.2007 US 883064 P; 10.04.2007 US 911077 P; 10.04.2007 US 733756
(43) Date of publication of application: 17.06.2009
(73) Proprietor: Féinics AmaTech Teoranta, County Mayo (IE)
(72) Inventor: FINN, David, Tourmakeady, County Mayo (IE)
(74) Representative: Cremer, Ulrike Theresia
(86) International application number: PCT/EP2007/059340
(87) International publication number: WO 2008/037579

(56) References cited:
- WO-A-00/21030
- DE-A-102004 045 896
- DE-A1- 19 646 717
- DE-A1- 19 745 648
- DE-C1- 19 920 399
- US-A1- 2001 054 230

## Description

### FIELD OF THE INVENTION

The invention relates to mounting an antenna wire (or antenna coil) on a substrate, and connecting end portions of the antenna wire to terminals of a transponder chip (or chip unit) which is also mounted to the substrate (or to an underlying substrate).

### BACKGROUND OF THE INVENTION

A conventional method to produce an inlay site containing a high frequency RFID chip and an antenna embedded into a multi-layer substrate and connected to the terminals (terminal areas) of the RFID chip is to first position the RFID chip in a recess, supported by a lower substrate layer, then start embedding (countersinking) a wire conductor onto or into the top substrate layer in the direction of the RFID chip, then guiding the wire conductor over a first terminal area of the RFID chip, then continue the embedding process by forming an antenna in the top substrate layer with a given number of turns, then guiding the wire conductor over the second terminal area, and finally embedding the wire conductor again into the top substrate layer before cutting the wire to complete the high frequency transponder site. In a next stage of the production process, the wire ends passing over the terminal areas are interconnected by means of thermal compression bonding. Adhesively placing a wire conductor onto the top substrate layer is an alternative to embedding, and typically involves self-bonding coated wire conductor.

A wire embedding apparatus may be an ultrasonic wire guide tool, known as a "sonotrode", with a wire feed channel (capillary) passing through the centre of the wire guide tool. The wire conductor is fed through the wire guide tool, emerges from the tip, and by application of pressure and ultrasonic energy the wire conductor is "rubbed" into the substrate, resulting in localised heating of the wire conductor and subsequent sinking of the wire conductor into the substrate material during the movement of the wire guide tool. A wire placement apparatus may also be an ultrasonic tool similar in function to an ultrasonic horn which heats the wire to form an adhesion with a substrate.

The German patent application DE 196 46 717 A1 discloses a method of forming an inlay comprising an antenna wire having two end portions and a site for a transponder chip, the site comprising two terminal areas. The method comprises mounting the antenna wire to a surface of a substrate. US 2001/054230 A1 describes a standard bonding process where a wire which forms the antenna is bond to the terminals of a chip. WO 00/21030 A1 discloses an RFID transponder having improved RF characteristics. A RFID chip is packaged and oriented with respect to the antenna circuit within a plastic moulded package. DE 10 2004 045 896 A1 discloses a transponder with antenna and flip-chip module. The antenna wire is not directly attached to the terminals of the flip-chip module but to a separate contact surface called connecting bridge. The terminals ot the flip-chip module are attached thereto as well.

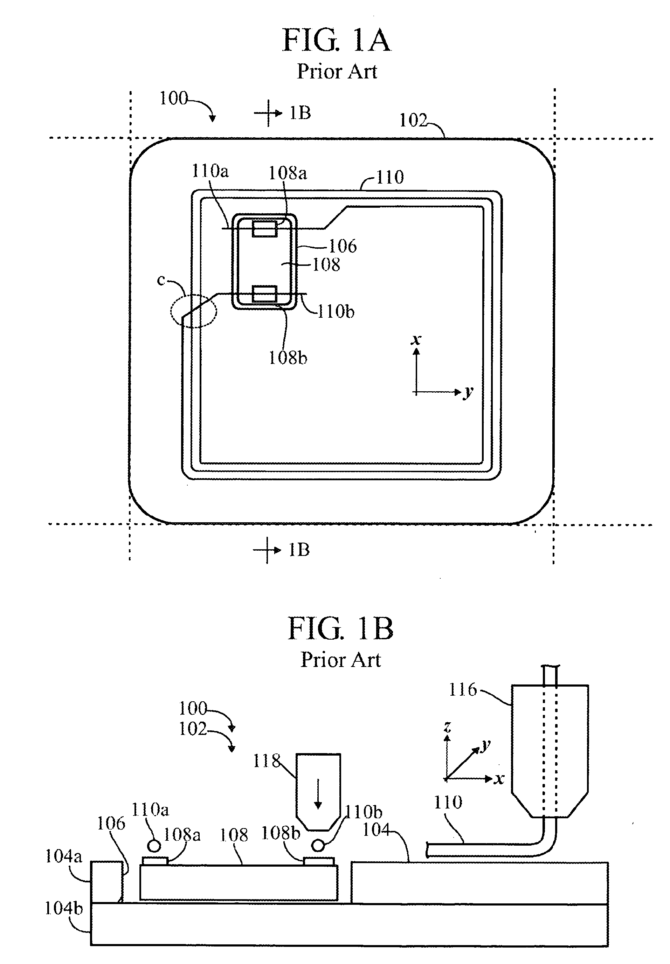

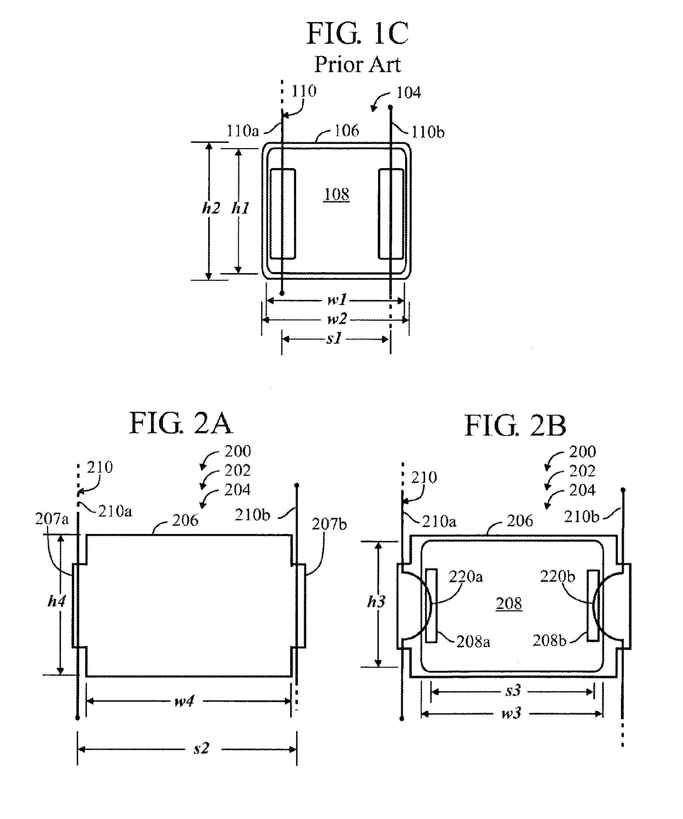

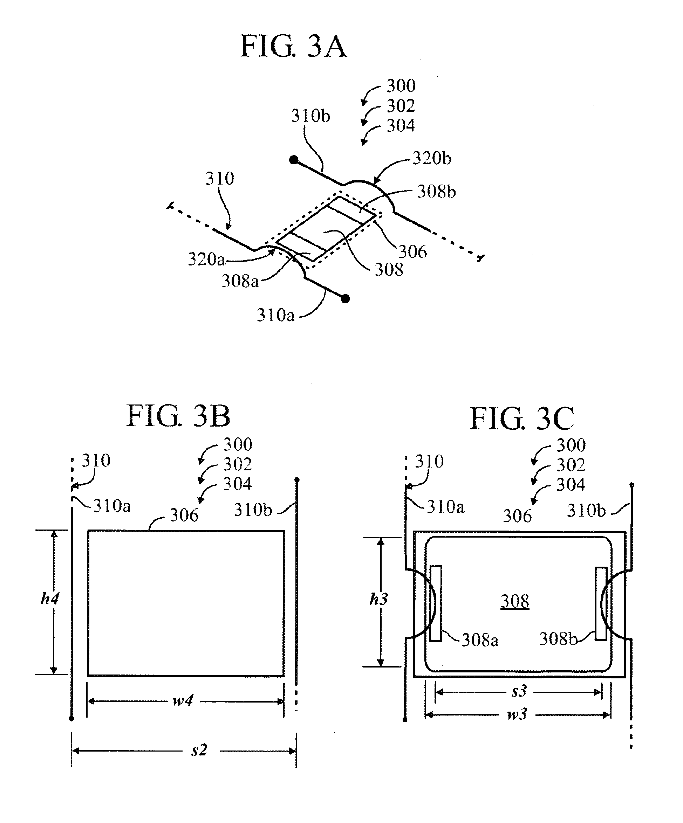

US Patent 6,698,089 ("089 patent") discloses a device for bonding a wire conductor. The device is configured for the contacting of a wire conductor in the course of the manufacture of a transponder unit arranged on a substrate and comprising a wire coil and a chip unit, wherein in a first phase the wire conductor is guided away via the terminal area or a region accepting the terminal area and is fixed on the substrate relative to the terminal area or the region assigned to the terminal area by a wire guide and a portal, and in a second phase the connection of the wire conductor to the terminal area is effected by means of a connecting instrument. FIGs. 1 and 2 of the 089 patent show a wire conductor 20 being embedded in a surface of a substrate 21, by the action of ultrasound. FIG. 3 of the 089 patent shows a wiring device 22 with an ultrasonic generator 34, suitable for embedding the wire. It is believed that the wiring device in the 089 patent can also be used for adhesively placing a wire.

### An Inlay and Transponder of the Prior Art

**FIGs. 1A** and **1B** illustrate an inlay substrate (or sheet) 100 having a plurality of transponder areas. A selected one of the transponder areas 102 constituting a single transponder is shown in detail. The vertical and horizontal dashed lines (in FIG. 1A) are intended to indicate that there may be additional transponder areas (and corresponding additional transponders) disposed to the left and right of, as well as above and below, the transponder area 102, on the inlay sheet 100. Such a plurality of transponders may be arranged in an array on the (larger) inlay sheet. As best viewed in FIG. 1B, the inlay sheet 100 may be a multi-layer substrate 104 comprising one or more upper (top) layers 104a and one or more lower (bottom) layers 104b.

A recess 106 may be formed in (through) the upper layer 104a, at a transponder chip site", so that a transponder chip 108 may be disposed in the recess, and supported by the lower layer 104b. The transponder chip 108 is shown having two terminals 108a and 108b on a top surface thereof. The transponder chip 108 may be a chip module, or an RFID chip.

Generally, the recess 106 is sized and shaped to accurately position the transponder chip 108, having side dimensions only slightly larger than the transponder chip 108 to allow the transponder chip 108 to be located within the recess. For example,
1. the transponder chip 108 may measure: 5.0 x 8.0 mm
2. the recess 106 may measure: 5.1 x 8.1 mm
3. the terminals 108a/b may measure: 5.0 x 1.45 mm
4. the wire (discussed below) may have a diameter between 60 and 112 µm

One millimeter (mm) equals one thousand (1000) micrometers (µm, "micron").

In **FIGs. 1A** and **1B**, the recess 106 may be illustrated with an exaggerated gap between its inside edges and the outside edges of the chip 108, for illustrative clarity. In reality, the gap may be only approximately 50µm - 100 µm (0.05mm - 0.1 mm).

In **FIG. 1A** the terminals 108a and 108b are shown reduced in size (narrower in width), for illustrative clarity. (From the dimensions given above, it is apparent that the terminals 108a and 108b can extend substantially the full width of the transponder chip 108.)

It should be understood that the transponder chip 108 is generally snugly received within the recess 106, with dimensions suitable that the chip 108 does not move around after being located within the recess 106, in anticipation of the wire ends 110a, 110b being bonded to the terminals 108a, 108b. As noted from the exemplary dimensions set forth above, only very minor movement of the chip 108, such as a small fraction of a millimeter (such as 50µm - 100 µm) can be tolerated.

As best viewed in **FIG. 1A**, an antenna wire 110 is disposed on a top surface (side) of the substrate, and may be formed into a flat (generally planar) coil, having two end portions 110a and 110b.

As best viewed in **FIG. 1B**, the antenna wire is "mounted" to the substrate, which includes "embedding" (countersinking) the antenna wire into the surface of the substrate, or "adhesively placing" (adhesively sticking) the antenna wire on the surface of the substrate. In either case (embedding or adhesively placing), the wire typically feeds out of a capillary 116 of an ultrasonic wire guide tool (not shown). The capillary 116 is typically disposed perpendicular to the surface of the substrate 100. The capillary 116 is omitted from the view in **FIG. 1A**, for illustrative clarity.

The antenna wire 110 may be considered "heavy" wire (such as 60 µm - 112 µm ), which requires higher bonding loads than those used for "fine" wire (such as 30 µm). Rectangular section copper ribbon (such as 60 x 30 µm) can be used in place of round wire.

The capillary 116 may be vibrated by an ultrasonic vibration mechanism (not shown), so that it vibrates in the vertical or longitudinal (z) direction, such as for embedding the wire in the surface of the substrate, or in a horizontal or transverse (y) direction, such as for adhesively placing the wire on the surface of the substrate. In **FIG. 1B****,** the wire 110 is shown slightly spaced (in drawing terminology, "exploded" away) from the substrate, rather than having been embedded (countersunk) in or adhesively placed (stuck to) on the surface of the substrate.

The antenna wire 110 may be mounted in the form of a flat coil, having two ends portions 110a and 110b. The ends portions 110a and 110b of the antenna coil wire 110 are shown extending over (**FIG. 1A**) and may subsequently be connected, such as by thermal-compression bonding (not shown), to the terminals 108a and 108b of the transponder chip 108, respectively.

Examples of embedding a wire in a substrate, in the form of a flat coil, and a tool for performing the embedding (and a discussion of bonding), may be found in the aforementioned US Patent No. 6,698,089 (refer, for example, to FIGs. 1, 2, 4, 5, 12 and 13 of the patent). It is known that a coated, self-bonding wire will stick to a synthetic (e.g., plastic) substrate because when vibrated sufficiently to soften (make sticky) the coating and the substrate.

In **FIG. 1B**, the wire 110 is shown slightly spaced (in drawing terminology, "exploded" away) from the terminals 108a/b of the transponder chip 108, rather than having been bonded thereto, for illustrative clarity. In practice, this is generally the situation - namely, the end portions of the wires span (or bridge), the recess slightly above the terminals to which they will be bonded, in a subsequent step. Also illustrated in **FIG. 1B** is a "generic" bond head, poised to move down (see arrow) onto the wire 110b to bond it to the terminal 108b. The bond head 118 is omitted from the view in **FIG. 1A**, for illustrative clarity.

The interconnection process can be inner lead bonding (diamond tool), thermal compression bonding (thermode), ultrasonic bonding, laser bonding, soldering, ColdHeat soldering (Athalite) or conductive gluing.

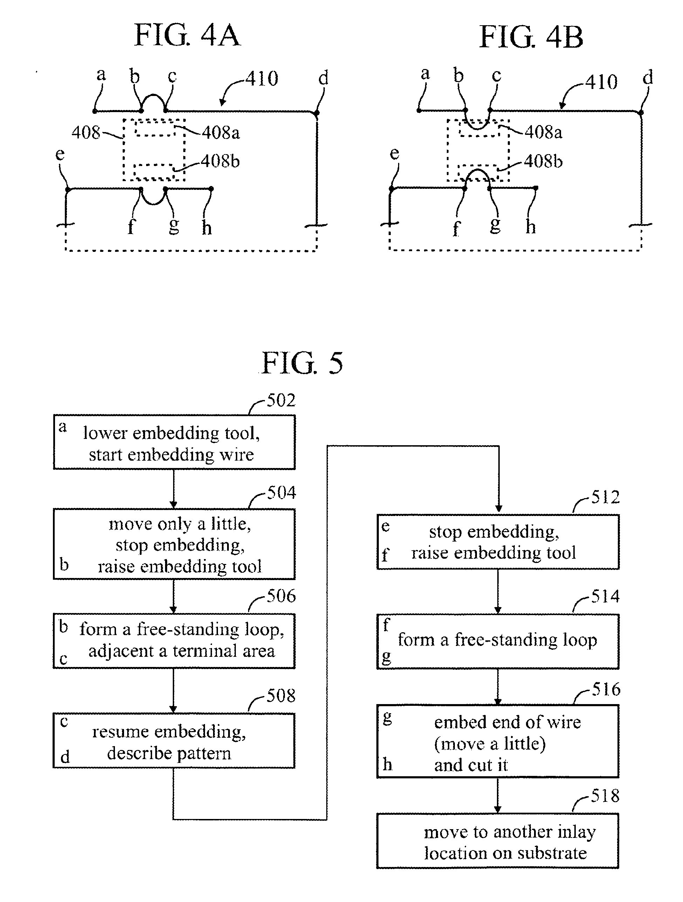

As best viewed in **FIG. 1A****,** in case the antenna wire 110 needs to cross over itself, such as is illustrated in the dashed-line circled area "c" of the antenna coil, it is evident that the wire should typically be an insulated wire, generally comprising a metallic core and an insulation (typically a polymer) coating. Generally, it is the polymer coating that facilitates the wire to be "adhesively placed" on (stuck to) a plastic substrate layer. (It is not always the case that the wire needs to cross over itself. See, for example, FIG. 4 of US Patent No. 6,698,089).

In order to feed the wire conductor back and forth through the ultrasonic wire guide tool, a wire tension/push mechanism (not shown) can be used or by application of compressed air it is possible to regulate the forward and backward movement of the wire conductor by switching the air flow on and off which produces a condition similar to the Venturi effect.

By way of example, the wire conductor can be self-bonding copper wire or partially coated self bonding copper wire, enamel copper wire or partially coated enamel wire, silver coated copper wire, un-insulated wire, aluminum wire, doped copper wire or litz wire.

**FIG. 1A** herein resembles FIG. 5 of US Patent No. 6,698,089 (the '089 patent), which has a similar coil antenna (50) with an initial coil region (51) and a final coil region (52) comparable to the antenna 110 with two end portions 110a and 110b described herein. In the '089 patent, the coil (50) is arranged on a substrate 55 which comprises a substrate recess (56, compare 106 herein) in the interior region (53) of the coil (50).

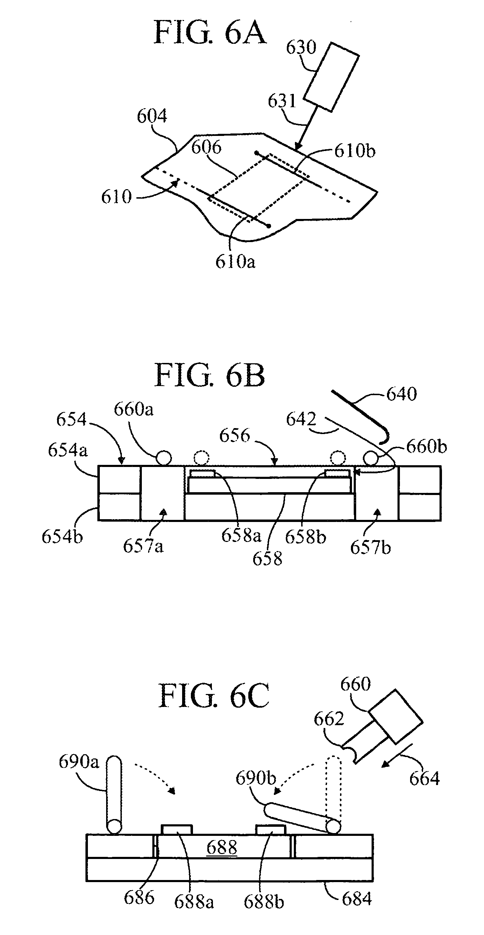

In FIG. 5 of the '089 patent, it can be seen that the initial and final coil regions (end portions) of the wires extend across the recess. In FIG. 6 of the '089 patent, it can be seen that the recess extends completely through the substrate. If the antenna is mounted to the substrate prior to the chip being installed in the recess (and the antenna is mounted to the front/top surface/side of the substrate, as shown), due to the fact that the antenna wires are "blocking" entry to the recess from the top/front surface of the substrate, the chip must be installed into the recess from the back (bottom) side of the substrate, as indicated by FIG. 6 of the '089 patent.

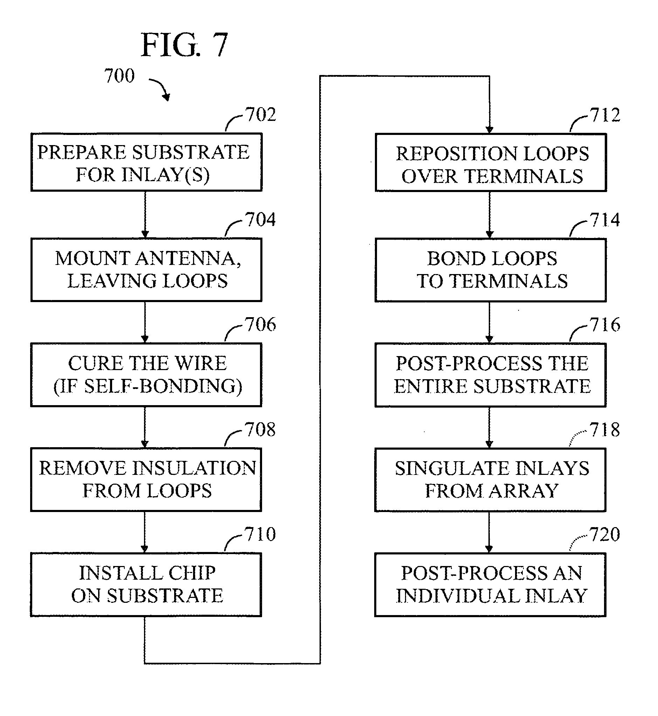

FIG. 7 of the '089 patent shows the subsequent (inter)connection of the terminal areas 59 of the chip unit 58 to the initial coil region 51 and to the final coil region 52 by means of a thermode 60 which under the influence of pressure and temperature creates a connection by material closure between the wire conductor 20 and the terminal areas 59, as an overall result of which a card module 64 is formed.

**FIG. 1C** shows the chip 108, having two terminals 108a and 108b is disposed in the recess 106 in a substrate (generally designated 104). The chip 108 may be rectangular, having a height dimension "h1" and a width dimension "w1". The chip 108 may measure 5.0mm by 8.0mm. The terminals 108a and 108b may be approximately 1.5mm wide, and may be generally located just within the left and right (as viewed) side edges of the chip 108. The recess 106 may also be rectangular (having the same shape as the chip), and may be only slightly larger than the chip, such as 0.1mm greater than the chip in both height and width. The recess 106 may measure 5.1 mm x 8.1 mm. Generally, the recess 106 is large enough to receive the chip 108, and securely locate it, so that the chip 108 does not shift position after being disposed in the recess 106.

End portions 110a and 110b of the antenna wire 110 pass directly over respective terminals 108a and 108b on the chip 108, and are subsequently bonded thereto, as discussed above. The wire 110 may have a diameter of approximately 0.1mm. The end portions 110a and 110b of the antenna wire 110 are spaced a distance "s1" apart from one another. The distance s1 is less than the chip width dimension w1, to ensure that the end portions 110a and 110b of the antenna wire 110 are positioned over the respective terminals 108a and 108b of the transponder chip 108.

The dashed lines extending from the top (as viewed) of the end portion 110a and the bottom (as viewed) of the end portion 110b indicate that the wire 110 continues, forming the antenna coil (see, for example, **FIG. 1A****)**. The round dots at the bottom (as viewed) of the end portion 110a and the top (as viewed) of the end portion 110b indicate that the wire ends (stops, does not continue).

A similar situation, wherein the end portions of the antenna wire spanning (or "bridging") the recess, directly above the chip terminals, is shown in FIGs. 4 and 5 of US Patent 6,698,089 ("089 patent"), incorporated by reference in its entirety herein.

A problem with the technique of mounting the end portions of the antenna wire so that they bridge (span across) the recess for the chip is that if the chip is installed (in the recess) from the front (antenna) side of the substrate it must be installed before the antenna is mounted (consequently, the antenna must be mounted with the chip in place). Else, if it is desired to install the chip after the antenna is mounted, the recess must extend all the way through the substrate (as a "window") and the chip must be installed from the opposite side of the substrate.

It is further discussed in the 089 patent that that a single ultrasonic instrument can be used both for fixation of the wire (mounting the wire on the substrate), and for connection of (bonding) the wire to the terminals of the chip. (column 15, lines 33-36)

The process described above with reference to FIGS. 14 and 15 of the 089 patent also offers the possibility, by appropriate choice of the points of fixation of the wire conductor on the substrate, of guiding the wire conductor away diagonally via the terminal areas, in order to increase the overlap between the wire conductor and the terminal areas. Also, several chips or other elements arranged in series on, or in, a substrate can be connected by means of the wire conductor in the manner represented in FIG. 14. (column 14, lines 39-47)

FIGs. 16 and 17 of the 089 patent show that a chip (132) may be introduced into the recess (114), after fixation of the wire conductor (113) on the surface of the substrate. As is evident, in order to accomplish this, the recess (114) extends fully through the substrate, and the chip is introduced from the opposite side of the substrate. Ends of the wire pass over the recess, generally in alignment with positions corresponding to terminals on the chip. After the chip is installed (FIG. 16), a connecting instrument enables a connection of the wire conductor to the corresponding terminal area. Also, as discussed in the 089 patent, in order to enable a positioning of the chip that is suitable for contacting of the wire conductor, the chip (132) is equipped on its contact side with a bridge-tape alignment aids (135), arranged adjacent to a terminal area, which provide for correct relative positioning via guide bevels (136).

### BRIEF DESCRIPTION (SUMMARY) OF THE INVENTION

It is a general object of an embodiment of the invention to provide improved techniques for fabricating inlays with transponders and, more particularly, to preparing end portion of an antenna wire mounted to the substrate for connection to terminals of the transponder including, but not limited to, (i) permitting a transponder chip to be positioned in a recess in a front side of a substrate after the antenna wire is mounted to the front surface of the substrate, and (ii) improving the quality of the interconnection and the long term reliability of the bonds.

These objects are generally achieved by a method disclosed in claim 1 and an inlay substrate discloses in claim 14. The subject-matter of said claims comprises the features of (i) mounting the antenna wire to the substrate so that end portions of the wire are spaced far enough apart so that a transponder chip may subsequently be positioned therebetween, then moving the end portions of the antenna wire to be over the terminals of the substrate and bonding them thereto, and (ii) removing insulation from the end portions of the wire, such as with a laser, prior to bonding (and typically prior to installing the transponder chip.

According to the invention generally, end portions of an antenna wire mounted to an inlay substrate are left un-mounted, and are pre-positioned adjacent (rather than within or above) a site (designated area) on the substrate for receiving a transponder chip. After the transponder chip is installed on the substrate, the end portions of the antenna wire are re-positioned to be over corresponding terminals of the transponder chip, for subsequent connection (bonding) thereto. Insulation from the wire may be removed prior to bonding.

According to the invention, a method of forming an inlay (200, 300) comprising an antenna wire (210, 310, 410) having two end portions (210a/b, 310a/b, 410a/b) and a site (206, 306) for a transponder chip (208, 308, 408), the site comprising two terminal areas (20/a/b, 308a/b, 408a/b) is characterized by forming the end portions of the antenna wire as free-standing loops (220a/b, 320a/b) adjacent the terminal areas. The site may be in a substrate which comprises a multi-layered substrate.

Mounting the antenna wire may comprises embedding the antenna wire in the surface of the substrate or adhesively placing the antenna wire on the surface of the substrate.

The end portions of the antenna wire may span the recess or slots as wire bridges (220a, 220b). The free-standing loops may be jump loops (320a/b).

The site for the transponder chip may comprise a recess in a multi-layer substrate. Slots may be provided in the substrate, adjacent opposite sides of the recess. The slots may be extensions of opposite sides of the recess.

A transponder chip (208, 308, 408) may be installed at the site, and the free-standing loop end portions of the antenna wire may be repositioned to be over corresponding terminals of the transponder chip, then bonded thereto. If the wire is insulated metallic wire, the coating of insulation may be removed from at least a portion of the free-standing loops prior to bonding. A laser (630) may be used to remove the coating, and slots may be provided in the substrate, under the portion of the free-standing loops whereat the insulation is removed.

The antenna may be formed by: mounting the wire conductor onto or into the substrate; passing the wire conductor over a first one of the slots in the substrate along a side the site for the transponder chip; routing the wire conductor to form an antenna with a given number of turns of insulated wire; and passing the wire conductor over a second one of the slots in the substrate along an opposite side of the site for the transponder chip. Insulation may be removed from a portion of the wire conductor passing over each slot in the substrate. A transponder chip may be installed at the site for the transponder chip, so terminals of the transponder chip are along side the respective wire conductor passing over a slot. The wire conductor may be drawn in over the terminals of the transponder chip, and bonded thereto.

According to an embodiment of the invention, a method of mounting an antenna wire (210, 310) to a surface of an inlay substrate (204, 304) and preparing end portions (210a/b, 310a/b) of the antenna wire for bonding to terminals (208a/b, 308a/b, 408a/b), 414) a transponder chip (208, 308, 408), comprises: at a point "a" on the surface of the substrate, commencing (502) mounting the antenna wire; continuing to mount the antenna wire (504) a short distance to a point "b"; forming a first free-standing loop (506) in the wire, between the point "b" and a point "c", adjacent a first terminal area (208a, 308a, 408a) for the transponder chip; resuming embedding (508) from the point "c" through points "d" and "e", to a point "f"; forming a second free-standing loop (514) in the wire, between the point "f" and a point "g", adjacent a second terminal area (208b, 308b, 408b) for the transponder chip; and continuing to mount the antenna wire (516) a short distance to a point "h", and at the point "h", and severing the wire.

According to an embodiment of the invention, an inlay substrate (204, 304) comprises an antenna wire (210, 310) mounted to a surface thereof, characterized by end portions (210a/b, 310a/b) of the antenna wire pre-positioned adjacent an area (206, 306) for a transponder chip (208, 308) which will be mounted to the substrate. End portions of the antenna wire may be formed as free-standing loops which may be wire bridges or jump loops.

According to an embodiment of the invention, a method of connecting an antenna wire having two end portions to a transponder chip comprises: designating a transponder chip site for the transponder chip in a surface of a substrate; and mounting the antenna wire to the surface of the substrate; and may be characterized by: installing the transponder chip at the transponder chip site, past the end portions of the antenna wire; and subsequently bonding the end portions of the antenna wire to corresponding terminals of the transponder chip. Insulation may be removed from end portions of the antenna wire, prior to bonding. The end portions of the antenna wire may be repositioned to be in alignment with the terminals of the transponder chip, prior to bonding.

Other objects, features and advantages of the invention will become apparent in light of the following description thereof.

### BRIEF DESCRIPTION OF THE DRAWINGS

Reference will be made in detail to embodiments of the disclosure, examples of which may be illustrated in the accompanying drawing figures (FIGs). The figures are intended to be illustrative, not limiting. Although the invention is generally described in the context of these embodiments, it should be understood that it is not intended to limit the invention to these particular embodiments.

Certain elements in selected ones of the figures may be illustrated not-to-scale, for illustrative clarity. The cross-sectional views, if any, presented herein may be in the form of "slices", or "near-sighted" cross-sectional views, omitting certain background lines which would otherwise be visible in a true cross-sectional view, for illustrative clarity. In some cases, hidden lines may be drawn as dashed lines (this is conventional), but in other cases they may be drawn as solid lines.

If shading or cross-hatching is used, it is intended to be of use in distinguishing one element from another (such as a cross-hatched element from a neighboring un-shaded element). It should be understood that it is not intended to limit the disclosure due to shading or cross-hatching in the drawing figures.

Elements of the figures may (or may not) be numbered as follows. The most significant digits (hundreds) of the reference number correspond to the figure number. For example, elements of Figure 1 are typically numbered in the range of 100-199, and elements of F1G. 2 are typically numbered in the range of 200-299. Similar elements throughout the figures may be referred to by similar reference numerals. For example, the element 199 in FIG. 1 may be similar (and possibly identical) to the element 299 in FIG. 2. Throughout the figures, each of a plurality of elements 199 may be referred to individually as 199a, 199b, 199c, etc. Such relationships, if any, between similar elements in the same or different figures will become apparent throughout the specification, including, if applicable, in the claims and abstract.
**FIG. 1A** is a top view of a transponder site, according to the prior art.
**FIG. 1B** is a side, cross-sectional view, partially exploded, of a wire being mounted to the substrate of **FIG. 1A** (and bonded to the terminals of the chip), according to the prior art.
**FIG. 1C** is a top view of a portion of a transponder site, showing transponder chip mounted in a recess, and end portions of an antenna wire bonded to respective terminals of the transponder chip, according to the prior art.
**FIG. 2A** is a top view of a portion of a transponder site, showing a recess and an antenna wire having end portions spanning (bridging) the recess, according to an embodiment of the invention.
**FIG. 2B** is a top view of a portion of a transponder site of **FIG. 2A****,** showing a transponder chip mounted in the recess, and the end portions of the antenna wire repositioned for bonding to respective terminals of the transponder chip.
**FIG. 3A** is a perspective top view of a transponder site, showing a recess and an antenna wire having end portions looped adjacent a recess for a transponder chip, according to an embodiment of the invention.
**FIG. 3B** is a top plan view of the transponder site shown in FIG. 3A, showing an initial step in the embodiment shown in FIG. 3A, according to the invention.
**FIG. 3C** is a top plan view of the transponder site shown in FIG. 3A, showing a further step in the embodiment of the invention.
**FIG. 4A** is a schematic illustration of forming loops at ends of an antenna wire which is mounted to (embedded in or place on) a substrate, illustrating an embodiment of a method, according to the invention.
**FIG. 4B** is a schematic illustration of re-positioning the loops of **FIG. 4A** over terminals of a transponder chip, according to the invention.
**FIG. 5** is a flowchart illustrating describing steps associated with the method of described with respect to FIGs. 4A and 4B, according to the invention.
**FIG. 6A** is a perspective view of a technique for removing insulation from wire bridges, according to an aspect of the invention.
**FIG. 6B** is a cross-sectional view of an inlay with a chip with wire bridges passing over slots adjacent a recess for a transponder chip and being manipulated (repositioned) over terminals of a transponder chip, according to an embodiment of the invention.
**FIG. 6C** is a cross-sectional view of an inlay with a chip and jump loops disposed adjacent a recess for a transponder chip and being manipulated (repositioned) over a terminal of a transponder chip, according to an embodiment of the invention.
**FIG. 7** is a diagram showing a manufacturing flow, according to an embodiment of the invention.

### DETAILED DESCRIPTION OF THE INVENTION

Various "embodiments" of the invention will be discussed. An embodiment is an example or implementation of one or more aspects of the invention(s). Although various features of the invention may be described in the context of a single embodiment, the features may also be provided separately or in any suitable combination.

It should be understood that the phraseology and terminology employed herein is not to be construed as limiting, and is for descriptive purposes only.

As used herein, an "inlay" is a generally planar substrate (or sheet), which may include several (a plurality of) distinct "transponder areas", arranged for example in a 3x6 array on the inlay sheet. The inlay sheet may have one or more (multiple) layers. A "transponder" may be fabricated in each "transponder area". Each "transponder" may include an antenna which is mounted to a surface (such as a top layer) of the substrate, and a "transponder chip" which is installed at a "transponder chip site"-(or "site for the transponder chip") on the substrate. The antenna is typically in the form of a flat coil having two ends which are connected to bond pads (terminals) on the "transponder chip". The "transponder chip" may be an individual integrated circuit (IC) chip, or a chip module (such as a chip mounted to a small substrate or a carrier). The "transponder chip site" of the "transponder" ( "transponder area" of the "inlay sheet") may comprise a recess (or window, or opening) extending through the top and one or more underlying layers of the substrate, such that the "transponder chip" can be installed in the recess, submerged below the surface of the "inlay sheet" and supported by an underlying layer of the substrate. A window may extend completely through the inlay sheet so that a transponder chip or chip module may be installed from an opposite (from the antenna) side of the inlay sheet. The following terminology may be used herein to describe embodiments of the invention.

When the term "inlay" is used herein, it may be taken to include any generally planar substrate, typically credit-card sized, made of a synthetic material or a coated non-synthetic material, such as paper. An inlay has an array of transponder sites, the format can be 3 x 6 for a card manufacturer. An inlay will typically comprise a (planar) substrate, a transponder (or RFID) chip, and an antenna (typically a flat coil of wire, having two ends).

When the term "substrate" is used herein, it should be taken to include non-conductive material, synthetic material, paper but also material coated with ferrite to create a Faraday cage or material used on stealth aircraft (to absorb or reflect electromagnetic waves). The substrate may be a multi-layer substrate (such as shown in **FIG. 1B**).

A suitable material for any of the substrates discussed herein is TESLIN, TYVEK, PC, PVC, PE, PET, PETE, Paper, C-FLEX, Paper or Cotton/Noil etc. in sheet format or endless roll (web) can be coated with adhesive film to protect the first chip and to support the process for manufacturing the inlay at the secure printing office. The substrate can also have special markings such as luminous threads, water marks, microscopic filings and optical polymer memory for additional security. A typical thickness for the substrate for passport inlays can be between 360 and 750 microns.
- PVC: short for polyvinyl chloride, (IUPAC Polychloroethene). PVC is a widely used thermoplastic polymer. It can be made softer and more flexible by the addition of plasticizers, the most widely used being phthalates.
- PET: short for Polyethylene terephthalate (also know as PET, PETE or the obsolete PETP or PET-P). PET is a thermoplastic polymer resin of the polyester family that produced by the chemical industry and is used in synthetic fibres; beverage, food and other liquid containers; thermoforming applications; and engineering resins often in combination with glass fiber. It is one of the most important raw materials used in man-made fibres.
- PETE: see PET.
- Teslin™: Teslin is a synthetic printing media, manufactured by PPG Industries. Teslin is a waterproof synthetic material that works well with an Inkjet printer, Laser printer, or Thermal printer. Teslin is also single-layer, uncoated film, and extremely strong. In fact, the strength of the lamination peel of a Teslin sheet is 2-4 times stronger than other coated synthetic and coated papers. Teslin comes in the sizes of 7 mil to 18 mil, though only sizes 10 mil and 14 mil are sized at 8.5" by 11", for printing with most consumer printers. Also available are perforated versions of Teslin, specifically, 2up, 6up, and 8up.

- Tyvek™: Tyvek is a brand of spunbonded olefin, a synthetic material made of high- density polyethylene fibers; the name is a registered trademark of the DuPont Company. The material is very strong; it is difficult to tear but can easily be cut with scissors or any other sharp object Water vapor can pass through Tyvek, but not liquid water, so the material lends itself to a variety of applications: medical packaging, envelopes, car covers, air and water intrusion barriers (housewrap) under house siding, labels, wristbands, mycology, and graphics.

When the term "transponder" is used herein, it may be taken to include any chip suitable for use in an inlay, such as an RFID chip.

When the term "chip" is used hereto it may be taken to include a chip module, or a chip unit. Generally, as used herein, "chip" is intended to mean RFID or transponder chip, Also, where applicable, "chip" may refer to a chip module or carrier or "strap".

When the term "wire" is used herein, it may be taken to include any elongate means for conveying or radiating signals, such as metallic wire (such as gold, aluminium, copper, silver), of any profile (such as round or rectangular), either bare, coated or colour coated, as well as optical fibers.

When the term "antenna" is used herein, it may be taken to include a simple coil antenna comprising wire having a number of turns, and two ends, a dipole antenna having two wire segments with two inner ends, or any other antenna configuration suitable for connection to a chip or chip module in an inlay.

When the term "mounting" is used herein (in conjunction with wire) it may be taken to include embedding or countersinking the wire into a surface of the inlay substrate and/or adhesively placing (bonding or sticking) the wire to the surface of the substrate. In some contexts, the term "embedding" may be be taken to include adhesively placing, if appropriate in the context (such as when describing mounting a self-bonding wire) - in other words, "embedding" may sometimes be used to mean "mounting" (which includes both "embedding" and ""adhesively placing").

When the term "bonding" is used herein, it may be taken to include any means of interconnecting (or simply "connecting"), both physically and electrically, a wire, or an end of the wire, or an end portion of the wire, to a terminal or connection pad on a chip or chip module. (Bonding typically comprises a kind of welding, but can include adhesively bonding and soldering.) The interconnection process can for example be inner lead bonding (heated diamond tool), thermal compression bonding (thermode), ultrasonic bonding or laser welding.

Generally, as used herein describing embodiments of the invention, the "transponder chip" is an electronic component comprising (having at least) two terminals, which may be a single chip, or a module comprising (having at least) a chip. Generally, the two terminals of the chip or module are interconnected with corresponding two end portions of the antenna wire which is mounted to a top surface of a substrate, which may be a multilayer substrate.

Generally, as used herein describing embodiments of the invention, the transponder chip is disposed in a "recess" or "cavity" which is an opening extending at least partially through the substrate. A "window" is generally an opening that may extend fully through the substrate. A "slot" is another opening (or hole) extending through the substrate next to a recess, cavity or window. In some embodiments, any of recess, cavity, window, or slot (and combinations thereof) may be used, and when the term "recess" is used, it should be understood to include all the variations and combinations, as may be appropriate from the context.

As used herein, a "recess" is generally (and usually) an opening extending only partially through a (typically) multilayer substrate (the recess may extend completely through top layers only), as may be exemplified by the recess 106 (FIG. 1B). The term "cavity" may be used interchangeably with "recess". A "window" is generally (and usually) an opening extending completely through a substrate (whether or not multilayer), as may be exemplified by the opening 56 in FIG. 6 of US 6,698,089.

The invention generally involves pre-positioning ends of an antenna wire adjacent a transponder site in preparation for connecting (bonding) to a transponder chip. When the term "pre-positioning" is used herein, it should be taken to include the location whereat the end portions of the antenna are located, in relation to the site for the transponder chip, and any form or shape imparted to the end portion of the wire.

When the term "adjacent" is used herein, it should be taken to mean other than (not) within the area of the site for the transponder chip, but rather next to the site for the transponder chip. As a result of the end portions of the antenna wire being pre-positioned adjacent the site for the transponder chip, rather than within (or over) the site for the transponder chip. Thus, the transponder chip can be installed at (or removed from) the site for the transponder chip unimpeded by the end portions of the antenna wire, since the end portions of the antenna wire are pre-positioned to not be over the site for the transponder, including installing the transponder chip from the same side of the substrate as the antenna.

Inasmuch as the pre-positioned end portions of the antenna wire will ultimately be repositioned to be over terminals of the transponder chip, for interconnection (such as by bonding) thereto, the end portions of the antenna wire can be as close as possible to the site for the transponder chip without impairing (or becoming damaged by) subsequent installation of the transponder chip. For example, the end portions of the antenna wire may be 0.5- 3.0 mm, such as 1.0 - 2-0mm away from a transponder area (or recess for the transponder chip).

A conventional method to produce an inlay is to embed insulated wire into a synthetic material (or a coated substrate), form an antenna coil on the substrate with a number of turns and interconnect the wire ends of the antenna to a transponder chip (or chip module). The interconnection of the antenna wire to the chip module is non-trivial, and it can be beneficial that the transponder chip (or chip module) can be installed on a substrate to which an antenna coil has already been mounted.

### "Wire Bridges"

**FIGs. 2A-2B** illustrate an embodiment of the invention which utilizes a "wire bridge" method, and in which a chip (or chip module) and the antenna are positioned on a common substrate, whereby the antenna resides on the top side (front surface) of the substrate and the chip may be inserted from either the top side or the bottom (opposite) side of the substrate.

Generally, the substrate has a rectangular recess (or cavity) to accommodate a rectangular transponder chip (or chip module) and end portions of the antenna wire pass over (span, bridge) the recess, or slots adjacent to the recess. The antenna is mounted to the front (top) side (surface) of the substrate, and the chip can be inserted into a recess extending only partway through the substrate from the front surface thereof, after the antenna is mounted to the front surface of the substrate. Or, the chip can be inserted in to a cavity extending all the way through the substrate, from the opposite back (bottom) side (surface) of the substrate.

Generally, in this embodiment, rather than the end portions of the wire passing directly over the terminals of the transponder chip, the end portions of the antenna wire are located adjacent to (next to, rather than directly over) the terminal areas of the chip, and thus initially forming a wire bridge on each side of the chip. After installing the transponder chip (or chip module) in the recess, the wire bridges can be re-positioned to be over terminals of the transponder chip, and bonded thereto. The repositioned wire bridges may be referred to as "planar loops".

**FIGs. 2A** and **2B** show a transponder site 202 (compare 102) on a substrate 204 (compare 104) which may be a portion of an overall inlay sheet 200 (compare 100), whereby a recess 206 (compare 106) is provided for a transponder chip 208 (compare 108). The transponder chip 208 may be disposed in the recess 206 after the antenna 210 (compare 110) is mounted to (embedded in or adhesively place on) the substrate 204.

Generally, in the embodiments disclosed herein, the recess (in this embodiment, 206; in another embodiment, 306) represents a "transponder chip site", or site (area, location) where a transponder chip will be mounted on the substrate, whether or not there is a recess. Such a transponder chip site constitutes a designated area of the substrate whereat the transponder is intended to be located. Generally, the transponder chip site will be a recess which is formed in the substrate, such as an opening in a top layer(s) of a multi-layer substrate. Also, the terminals (in this embodiment, 208a/b; in another embodiment, 308a/b; also 408a/b) represent "terminal areas" which are areas whereat the terminals of the transponder chip will be, after it is mounted and, as such, have a predetermined relationship to the transponder chip site (or recess).

The chip 208, has two terminals 208a and 208b (compare 108a and 108b), and may be rectangular, having a height dimension "h3" and a width dimension "w3". The chip 208 may measure 5.0mm by 8.0mm (the chip 208 may have the same dimensions as the chip 108).

The recess 206 may also be rectangular (generally, the same shape as the chip), having a height dimension "h4" and a width dimension "w4". The height dimension h3 of the recess may be only slightly larger, such as 0.1mm greater, than the height dimension h2 of the chip. The width dimension w4 of the recess may be only slightly larger, such as 0.1 mm greater, than the width dimension w3 of the chip. This is generally the same as the situation illustrated in **FIG. 1C****.**

End portions 210a and 210b of the antenna wire 210 do not pass directly over respective terminals 208a and 208b of the chip 208. (The end portions 210a and 210b of the antenna wire 210 do not pass over an area which will be occupied by the chip 208.) Rather, the two end portions 210a and 210b of the antenna wire span (bridge) the recess 206, and are spaced apart from one another a distance (s2) which is greater than the width (w3) of the chip 208, so that the chip 208 can be inserted into the recess 206 from the same side of the substrate 204 as the antenna, past the end portions 210a and 210b of the wires, after the antenna has been mounted (embedded in or adhesively placed on) to the substrate 204. Subsequently, as described in greater detail hereinbelow, the end portions 210 and 210b of the wire 210 are manipulated (re-positioned, moved, stretched) so as to be over the terminals 208a and 208b, and are bonded thereto.

Portions of the end portions 210a and 210b of the antenna wire 210 which pass over the recess 206 or slots 207a and 207b and may be referred to as "wire bridges". When repositioned to be over the terminals 208a and 208b of the chip 208, the wire bridges may be referred to as "planar loops" 220a and 220b. Although shown in FIG. 2A as passing straight over the recess (or slot), the end portions of the wire may make a bowed (non-straight, such as curved) transit over the recess (or slot).

This method of re-positioning the wire conductor may requires a tool (described hereinbelow) to form or grip the wires and re-position them above the terminals of the transponder chip, in preparation for interconnection (bonding) with the terminals of the transponder chip. Such a tool is well known, and may be referred to in the industry as a "wire gripper". The tool can generally be in the form of an elongate member terminating in a hook, like a crochet needle, having a diameter approximately equal to the diameter of the wire being gripped (and moved).

The dashed lines extending from the top (as viewed) of the end portion 210a and the bottom (as viewed) of the end portion 210b indicate that the wire continues, forming the antenna coil (see **FIG. 1A**). The round dots at the bottom (as viewed) of the end portion 210a and the top (as viewed) of the end portion 210b indicate that the wire ends (stops, does not continue).

In this embodiment, slots 207a and 207b are provided on the left and right (as viewed) side edges of the recess 206. The slots 207a and 207b may extend fully through the substrate 204, while the recess 206 may extend only partially through the substrate 204. The slots 207a and 207b are shown as being shorter (less height, in the vertical direction as illustrated) than the side edges of the recess 206. The slots 207a and 207b may be considered to be "widthwise extensions" of the recess 206 and, as such, may be considered simply to be side edge portions of the recess 206. In this aspect, the slots 207a and 207b extending from the side edges of the recess 206 could be the full height dimension (h4) of the recess, rather than being shorter, as illustrated. The slots 207a and 207b are shown disposed adjacent opposite sides of the recess 206, as extensions thereof. The slots 207a and 207b may otherwise be separate from the recess 206, adjacent and spaced from the side edges thereof.

The slots 207a and 207b (whether or not considered to be a part of the recess, per se) provide an area under the wire bridge spanning the slot which is deeper than the recess 206, such as fully through the substrate, to allow a hook or wire gripper to pass easily under the wires. The chip resides in the recess, but the slots 207a and 207b provide "windows" under the "wire bridges" which allows the end portions of the wire to be gripped more easily for positioning purposes, either from the top or bottom of the substrate, or both.

Some advantages to having the slots 207a and 207b include that they can provide an opportunity to install an optical mechanism in conjunction with a UV laser for insulation removal (removing coating from the wire bridges, prior to bonding). In use, one would have an insulation removal station in the transponder line and the laser can remove the insulation from all sides of the wire without restrictions. It also avoids any damaging or markings to the substrate. A mirrored surface under the slots can also be used, in conjunction with a vision system, to ensure that the insulation is completely removed. Also, during the bonding process, slots under the positioned chip and wire can be advantageous as one can support the chip with a well-defined surface during bonding. Insulation removal is discussed in greater detail hereinbelow.

As illustrated in **FIG. 2A****,** prior to installing (placing, locating, disposing) the chip 208 in the recess 206, an antenna is formed by passing a wire conductor 210 over the slotted cavity area 207a, forming an antenna, and finally passing the wire conductor over the second slotted cavity 207b. The wire conductor on each side of the chip cavity or chip recess forms wire bridges. The wire bridges are mounted into or onto the substrate, and therefore are in a fixed position.

Generally, in any of the embodiments described herein, it is also possible to remove the insulation before proceeding to the next step in the process, such as prior to bonding the end portions of the antenna wire (wire bridges) to the terminals of the transponder chip (or chip module).

**FIG. 2B** illustrates the placement of a chip 208 into the recess 206, and the subsequent repositioning of the wire bridges 210a and 210b over the terminal areas 208a and 208b of the chip 208 for subsequent bonding thereto (bonding is not shown, it is known, see bond head 118, **FIG. 1**).

If the recess 206 extends only partially through the substrate 204 (compare recess 106, FIG. 1), the chip 208 can be placed in the cavity, after the antenna is mounted, with the wire bridges in place, since the wire bridges are spaced apart from one another wider than the width dimension w3 of the chip 208. Alternatively, the recess (or cavity) 206 can extend completely through the substrate 204, in which case the chip could be inserted from the bottom of the recess (or window).

Note that the wires are spaced farther apart than width of chip (which means that the chip can be inserted from the top side), then (after chip is in place) the wires are re-positioned inward to be over the terminals. The wire bridges may be moved into position with a wire gripper tool (not shown).

After the end portions 210a and 210b of the antenna wire 210 are moved into position over the respective terminals 208a and 208b of the transponder chip 208, they are spaced a distance "s3" apart, which corresponds to the distance between the two terminals 208a and 208b (compare wire spacing "s1" in **FIG. 1C**).

This method of re-positioning the wire conductor requires a tool (not shown) to form or grip the wires and re-position them above the terminals of the transponder chip, in preparation for interconnection (bonding) with the terminals of the transponder chip. Such a tool is well known, and is referred to in the industry as a "wire gripper". The tool can be in the form of an elongate member terminating in a hook, like a crochet needle, having a diameter approximately equal to the diameter of the wire being gripped (and moved). See, for example, **FIG. 6B**. In use, two of these hooks, positioned generally parallel with one another and spaced approximately one wire diameter apart, can be used to pull on the wire from two points, rather than one. In **FIG. 2B**, the re-positioned wire is shown semicircular. It should be understood that if one hook were used to pull on a wire, the repositioned wire would look more triangular (with an apex), and if two closely-spaced hooks were used to reposition the wire, it would look like a triangle with a flat apex (a trapezoid).

In use, a transponder site commences with the wire conductor being mounted into or onto the substrate over a short distance, then drawing the wire conductor over a cavity (or recess) to accommodate the chip as well as the wire bridges and mounting the wire conductor into or onto the substrate in forming an antenna, then drawing the wire conductor over the cavity on the opposite side to create a second wire bridge and finally mounting the wire conductor into or onto the substrate over a short distance before cutting the wire.

In a next step of the process, the insulation of the wire conductor may be removed in preparation for interconnection. The wire is formed so that a loop will extend over the terminal areas of the chip. The forming of the wire can also be before insulation removal.

The chip may be positioned (installed, located, disposed) in the cavity from above or from below (if the recess extends fully through the substrate) using a vacuum suction system to keep the chip in place. And finally, the end portions of the antenna wire are connected to the terminals of the chip.

An advantage to various embodiments of the invention disclosed herein, those that involve mounting the antenna wire before installing the transponder chip, is that this facilitates removal of insulation (coating) from the antenna wire at the end portions of the wire (wire bridges) where bonding to the terminals of the transponder chip (or chip module) will occur. Various problems which may thus be avoided or minimized may include damaging the chip, unwanted reflections from the chip, accessibility to perform the insulation removal process, inspectability of the insulation removal process, etc.

### "Jump Loops"

**FIGs. 3A-3C** illustrates an embodiment of the invention which utilizes a "looping" method, and in which a chip (or chip module) and the antenna are positioned on a common substrate, whereby the antenna resides on the top side (front surface) of the substrate and the chip may be inserted from either the top side or the bottom (opposite) side of the substrate.

Generally, the substrate has a rectangular recess or cavity to accommodate a rectangular chip module and the end portions of the antenna wire, which pass nearby (adjacent to) the cavity. The antenna is mounted to the front (top) side (surface) of the substrate, and the chip can be inserted into a recess extending only partway through the substrate from the front surface thereof, after the antenna is mounted to the front surface of the substrate. Or, the chip can be inserted in to a cavity extending all the way through the substrate, from the opposite back (bottom) side (surface) of the substrate.

Generally, in this embodiment, rather than the end portions of the wire passing directly over the terminals of the transponder chip, the end portions of the antenna wire are located adjacent to (next to, rather than directly over) the terminal areas of the chip, and are in the form of loops which extend vertically from the surface of the substrate, in the manner of wire bond loops.

Wire bonding, which is a packaging step which has been used for many years to connect a die to a the package, is a form of interconnection which consists of the performance of a basic bonding cycle: a) formation of the first bond on the die; b) pulling of the wire to the lead frame or bonding post of the package where the second bond will be formed; c) formation of the second bond; and d) cutting of the wire in preparation for the next cycle. The step (b), which feeds and forms the wire that runs from the first to the second bond, involves an action often referred to as 'looping', wherein the wire fed between the bonds takes the form of an arc. The arc formed when the bonding tool traveled in a natural parabolic or elliptical curve is the 'wire loop'. The wire loop is characterized by its shape, length, and height, all of which define what is known as the wire's 'loop profile'.

**FIGs. 3A - 3C** illustrate a transponder site 302 (compare 102, 202) on a substrate 304 (compare 104, 204) which may be a portion of an overall inlay sheet 300 (compare 100, 200); whereby a recess 306 (compare 106, 206) is provided for a transponder chip 308 (compare 108, 208). The transponder chip 308 may be disposed in the recess 306 after the antenna 310 (compare 110, 210) is mounted to (embedded in or adhesively place on) the substrate 304.

The chip 308, has two terminals 308a and 308b (compare 208a and 208b), and may be rectangular, having height "h3" and width "w3" dimensions comparable to those of the chip 208. The recess 106 may also be rectangular, having height "h4" and width "w4" dimensions comparable to those of the recess 206. Slots (207a and 207b) may or may not be provided, and are omitted, for illustrative clarity.

End portions 310a and 310b of the antenna wire 310 do not pass directly over respective terminals 308a and 308b of the chip 308. (The end portions 310a and 310b of the antenna wire 310 do not pass over an area which will be occupied by the chip 308.) Rather, the two end portions 310a and 310b of the antenna wire are formed into "loops" 320a and 320b which are disposed adjacent opposite sides of the recess 306, and are spaced apart from one another a distance (s2) which is greater than the width (w3) of the chip 308, so that the chip 308 can be inserted into the recess 306 from the same side of the substrate 304 as the antenna, past the end portions 310a and 310b of the wires, after the antenna has been mounted (embedded in or adhesively placed on) to the substrate 304. Subsequently, as described in greater detail hereinbelow, the end portions 310 and 310b of the wire 310 are manipulated (re-positioned, moved, stretched) so as to be over the terminals 308a and 308b, and are bonded thereto. The loops 320a and 320b of this embodiment may be referred to as "jump loops". The jump loops 320a and 320b may be approximately 2.5mm in height, and may be pre-positioned approximately 1.5 mm distant from the terminal areas 308a and 308b of the transponder chip 308 (or from the side edges of the recess 306).

The dashed lines extending from the top (as viewed) of the end portion 310a and the bottom (as viewed) of the end portion 310b indicate that the wire continues, forming the antenna coil (see F**IG. 1A**). The dots at the bottom (as viewed) of the end portion 310a and the top (as viewed) of the end portion 310b indicate that the wire ends (stops, does not continue).

Attention is directed to end portions 310a and 310b (compare 210a and 210b) of the antenna wire 310. The end portions 310a and 310b will ultimately be connected to corresponding terminals 208a and 208b, respectively, of the transponder chip 208.

More generally, if the transponder chip 308 is not already in place when the antenna wire 310 is mounted to the substrate, and the two loops 320a and 320b are formed, the reference numeral 308 would refer to a "site" for a transponder chip (or chip module), the reference numeral 308a would refer to a first "terminal area", and the reference numeral 308b would refer to a second "terminal area". Alternatively, a recess or cavity 306 (described in the next paragraph) can be considered to be the "site" for the not-yet-in-position transponder chip 308.

The recess or cavity 306 may be formed in the surface of the substrate 304 to help align (locate), as well as to recess (lower the position of), the transponder chip 308. In a multilayer substrate, the recess or cavity 308 may extend into the substrate from a surface of the substrate, through at least a top layer (compare 104a) of the substrate, extending to a lower layer (compare 104b) of the substrate. When the transponder chip 308 is disposed in (received by) the cavity 306, it will be supported by the lower layer(s) of the substrate. A multi-layer substrate has been illustrated in **FIG. 1B****.**

The loop portions 320a and 320b of the end portions 310a and 310b of the antenna wire 310 (or wires, plural, in the case of a dipole antenna) are not mounted to (embedded in or adhesively placed on) the substrate 202. Rather, in the process mounting, described in greater detail hereinbelow, the loop portions 320a and 320b of the end portions 310a and 310b of the antenna wire 310 are left un-mounted, and are thus "free-standing". In this embodiment, the loop portions 320a and 320b of the end portions 310a and 310b of the antenna wire 310 are each formed as generally upside-down U-shaped loops, similar in appearance to a conventional wire-bonding loop. Each of these loops 320a and 320b formed in the end portions 310a and 310b of the antenna wire 310 may be in a plane which may be substantially perpendicular to the surface of the substrate 304. Generally, if the plane of the loops is inclined, it should be inclined away from the transponder site so as not to interfere with subsequent installation of a transponder chip, past the loops, at the transponder site (such as into the recess 306).

When the term "loop" is used herein, it may broadly be taken to include jump loops (like traditional wire bonding loops), planar loops, wire bridges, meanders, and any configuration of end portions of the antenna wire pre-positioned adjacent the recess or transponder area so as to permit installation of the transponder chip from the same side of the chip as the antenna, past the pre-positioned (looped) end portions of the antenna wire.

An important feature of the loops 320a and 320b is that they are located adjacent (next to, along side of) first and second terminal areas (or terminals 308a and 308b, if the transponder chip 308 is in place) for the transponder chip 308, in preparation for connecting the loops 320a and 320b to the terminals 308a and 308b of the transponder chip 308 (once it is in place). The loops 320a and 320b can be manipulated, so that in a next step (illustrated in **FIG. 3C**) they will be positioned above the terminals 308a and 308b of the transponder chip 308 (once the transponder chip 308 is in its place (306) on the substrate 304).

**FIG. 3C** illustrates that the loops 320a and 320b are subsequently (such as after the transponder chip is in place) manipulated (drawn in, deflected, moved, bent, repositioned, extended) to be substantially directly over the terminals 308a and 308b of the transponder chip 308, in preparation for interconnection (such as bonding) to the terminals 308a and 308b of the transponder chip 308.

The transponder chip 210 may or may not have been in place prior to mounting the antenna and forming the loops. In **FIGs. 3A** and **3C**, the transponder chip 308 is shown already in place, located in a cavity or recess 306 (shown in dashed lines in FIG. 3A) formed in the surface of the inlay substrate 304 to accommodate (receive, locate, recess) the transponder chip 308.

When the transponder chip 308 is in place (installed on the substrate, at the transponder site), the loops are drawn in (re-positioned, manipulated to be) over the terminals, and then the loops are connected (bonded) to the terminals of the transponder chip. If the wire is an insulated wire, there may (or may not) be an insulation removal step before connecting (bonding) the loops to the terminals.

This method of re-positioning the wire conductor may require a tool (described hereinbelow) to push the loops over, thereby re-positioning them to be above the terminals of the transponder chip, in preparation for interconnecting (bonding) them to the terminals of the transponder chip. Such a tool is well known, and may be referred to in the industry as a "wire gripper", and may be similar in design to the hooks used in a pull tester to calculate bond force.

It should be understood that it is not necessary to bond an entire loop (320a, 320b) to a terminal (308a, 308b), rather only a portion thereof, such as a tip (apex) portion of the loop.

It should also be understood that if the antenna wire is an insulated wire, having one or more coatings to assist (for example) in mounting by adhesively placing the antenna wire on the substrate, the coating(s) (self bonding coat and insulation layer) should be removed prior to bonding. Removal of the coating(s) (insulation) from an insulated wire (from the loops, or from tips of the loops - importantly from a portion of the wire that will be bonded to the terminal(s) of the transponder chip) are discussed in greater detail hereinbelow (and may involve using apparatus such as a laser or a hot iron to remove the coating(s)), and can be donc (performed) either during mounting the antenna wire, or after having mounted the antenna wire over slots and formed the loops in preparation for bonding.

A self-adhering wire may comprise: a metallic core, a first non-metallic coating disposed on the surface of the metallic core; and a second non-metallic coating disposed on the surface of the first metallic coating. The core may comprise copper, aluminum, doped copper, gold, silver or Litz wire, and may have a diameter of 0.010 - 0.50mm (AWG 24-58) (0.010mm = 100 micron). The range would normally be 10 to 150 microns (µm). The first non-metallic coating, or "base coat" may comprise modified polyurethane, and may have a thickness of only a few microns. The second non-metallic coating, or "bond coat" may comprise polyvinylbutyral or polyamide, and may have a thickness of only a few microns.

**Litz wire** Litz wire is a special type of wire used in electronics. It consists of many thin wires, individually coated with an insulating film and braided, thus increasing the surface area of the conductor and thereby reducing the skin effect and associated power losses when used with high-frequency applications. The word originated from Litzendraht, German for braidswire.

**FIGs. 4A** and **4B** illustrate, schematically, an example of embedding (or adhesively placing) a wire 410 (compare 210, 310) in a substrate (compare 204, 304), forming loops 420a and 420b (compare 320a and 320b) adjacent terminal areas (or terminals) 408a and 408b of a transponder site (not shown, compare 206, 306) or transponder 408 (compare 208, 308), and forming a pattern such as a rectangular coil pattern for an antenna wire 410 (compare 210, 310). **FIG. 5** is a listing of the steps (method) involved. Any suitable tool for mounting (embedding or adhesively placing) the wire 410 to the substrate may be used, such as the tool disclosed in US 6,698,089. Some dimensions may be used to illustrate the process, and it should be understood that the dimensions set forth herein are exemplary and illustrative, and should not be construed as limiting.

The embedding tool may be lowered onto the substrate, and the embedding process commences, at a "starting point" labelled "a". Generally, embedding is accomplished by vibrating. See step 502 - lower embedding tool, start embedding wire.

The embedding tool then moves in a plane (x-y) parallel to the surface of the substrate, but only a short distance sufficient to ensure embedding of the wire, to the point "b", and then the embedding tool stops vibrating and raises up. The distance between the points "a" and "b" may be 5 to 8 mm. See step 504 - move only a little, stop embedding, raise embedding tool.

Next, the embedding tool is moved, and this many include rotationally positioning the wire guide, to form a free-standing loop in the wire, between the points "b" and "c". Typically, the free-standing loop will be formed adjacent a terminal area of a device (as discussed hereinabove, which may be before (or after) the device (the transponder chip) is mounted to the substrate The distance between the points "b" and "c" may be 3-5 mm for a chip, or 4-5 mm for a chip module. See step 506 - form a free-standing loop adjacent a terminal area.

The loop (between the points "b" and "c") may be a "jump" loop similar to a wire bonding loop, in a plane which is substantially perpendicular to the surface of the substrate, or the loop may be a wire bridge over a slot in the substrate, substantially in the plane of the substrate. In either case the end portion of the antenna wire is pre-positioned adjacent the terminal area 408a.

Next, at the point "c", loop formation is finished, the embedding tool may again be lowered, embedding of the wire resumes (ultrasonic vibrations start), and the embedding tool moves along a prescribed path, parallel to the surface of the substrate, to form a desired pattern, such as the square coil for the antenna (see, for example, the antenna 110 **FIG. 1A**). See step 508 - resume embedding, describe pattern.

It may be noted, for example, at the point "d", the embedding tool would need to make a 90-degree turn to form a subsequent (second) side of a rectangular coil antenna. The 90-degree corner angle at point "d" is by way of example. Generally, at some point in making the pattern, the tool will have to make some angle, which need not be 90-degrees, it could be more, or less. (Eventually, after moving around the substrate, mounting (embedding or adhesively placing) the antenna wire, the embedding tool will need to return to near its starting point.)

If the wire feeds out of the center of a sonotrode (such as is shown for example in FIG. 1 of US 6,698,089) there is rotational symmetry, and the embedding tool may move around the surface of the substrate, changing direction without rotating. If the wire is fed to under the sonotrode (or equivalent) from a side of the sonotrode (such as is shown for example in FIG. 12 of US 6,698,089) there is a lack of rotational symmetry, and the embedding tool will need to turn itself to change the direction of wire mounting.

After mounting the antenna in the desired pattern, and making a final turn at the point "e", embedding continues to a point "f". The next step is similar to the second part of the step 504. At the point "f", the embedding tool stops vibrating and raises up. See step 512 - stop embedding, raise embedding tool.

The next step is similar to the step 506. A free-standing loop in the wire is formed between the points "f" and "g", adjacent a second terminal area of a device (as discussed hereinabove, which may be before (or after) the device is mounted to the substrate The distance between the points "f" and "g" may be 4 to 5 mm for a chip module. See step 514 - form a free-standing loop.

The next step is similar to the first part of the step 504. The embedding tool then moves in a plane (x-y) parallel to the surface of the substrate, but only a short distance sufficient to ensure embedding, to the point "h", and then the embedding tool stops vibrating and a cutting tool (which is typically associated with the embedding tool) severs (cuts) the wire. See step 516- embed end of wire, move a little, and cut it.

The embedding tool can then move to another location on a substrate to prepare another site with an antenna and loops. See step 518 - move to another inlay (transponder) location on the inlay substrate.

Note that in **FIG. 4A** the loops are illustrated as being formed in an opposite direction from how they may ultimately be attached to the terminals 408a, 408b of the device, rather than upstanding (in a plane perpendicular to the plane of the substrate). This is simply to illustrate, schematically, that the loops may be formed other than over the terminals of the device, later to be moved (deflected, repositioned) over the terminals, then bonded to the terminals.

In **FIG. 4B**, the loops are shown having been re-positioned over the terminals 408a, 408b of the device (which, once the transponder chip is installed is the terminals themselves), for subsequent bonding to the terminals of the transponder chip.

Bonding then may proceed in any conventional manner. The wire ends of the antenna, now residing over the terminals of the transponder chip, are bonded to the terminals of the chip. The interconnection (bonding) process can for example be inner lead bonding (diamond tool), thermal compression bonding (thermode), ultrasonic bonding or laser welding. Prior to interconnection the insulation layer of the wire conductor can be removed.

Two embodiments for pre-positioning end portions of an antenna wire (or two antenna wires, in the case of a dipole antenna) have been described. In both embodiments, the wire bridge or jump loop comprises an un-mounted (free-standing) end portion of the antenna wire, substantially the entire remainder of the antenna wire being mounted to (embedded in or adhesively positioned on) the substrate. The free-standing end portions of the antenna wire, whether wire bridges or jump loops or the like (other configurations are possible), may be referred to herein as "free-standing loops".

Some important features of the invention disclosed herein include pre-positioning end portions of the antenna wire adjacent a transponder chip area (or recess), and sufficiently wide apart so that the transponder chip may be installed, after the antenna wire has been mounted, from the same side of the substrate as the antenna. Because the antenna wire may be mounted before the transponder chip is installed, insulation may be removed from portions of the antenna wire which will be bonded to the terminals of the transponder chip without interference from, or damage to the transponder chip.

### Thermode Ageing

The conventional method to interconnect the wire ends of an antenna to the terminal areas of a chip module is by means of thermal compression bonding. The method makes use of heat by passing pulses of electric current through a thermode and simultaneously applying pressure to cause a diffusion process between the wire and the lead frame of the chip module. The main disadvantages of thermal compression bonding are the ageing of the thermode which requires regular replacement and residues of wire insulation remaining underneath the bonded wire which affects the long term reliability of the interconnection.

This thermode ageing problem can be exacerbated if the chip is not held securely in place, on a rigid work surface. The approach described hereinabove, with respect to FIGS. 4A-4E, provide an opportunity to keep the chip in a fixed position, while causing the aforementioned relative motion between the chip and the wire bridges to bring the terminals of the chip into position for bonding thereto.

Normally (such as may be exemplified by FIGs 14 and 15 of US 6,698,089), the chip is mounted into the recess first and then the wire is embedded in the substrate. The wires cross over the terminal areas of the chip and thus lie above the terminals. This means that the chip is supported by an underlying substrate. This can cause problems, as follows. Since the chip is supported by the underlying substrate (synthetic material) which is elastic, its surface is not ideal for the bonding process.

For a reliable interconnection and to prevent rapid ageing of the thermode during thermal compression bonding, the surface should be hard like ceramic. Therefore, the current technique of placing the chip in a recess before embedding or placing the chip from below is not conducive for a reliable interconnection in the next stage of the process. The number of bonds which can be achieved using the traditional method is 5,000, whereas with a ceramic plate (heated hot plate), the thermode can withstand 20,000 bonds.

### Tools (FIGs. 6A-6C)

Generally speaking, the present invention may be implemented using conventional tools. Some tools have been described hereinabove. Die bonders (such as Kulike and Soffa, Willow Grove, PA) use many of the same tools and techniques, such as suction pipette, heated work plate, and the like. A suitable tool for mounting the wire to the substrate is shown in US Patent 6,698,089, and need not be discussed further herein. The use of a laser for removing insulation from the wire bridges has briefly been discussed. The use of a hook or gripper for grabbing and repositioning the wire has been discussed.

**FIG. 6A** illustrates an exemplary technique for removing insulation from end portions 610a and 610b (compare 210a/210b, 310a/310b) of an antenna wire 610 (compare 210, 310), according to an aspect of the invention. A substrate 604 (compare 204, 304) has a recess 606 (compare 206, 306), which may include slots (207a, 207b). End portions 610a and 610b (compare 210a/b, 310a/b, 410a/b), are shown as "wire bridges", spanning the recess 606 (or slots), by way of example only. The end portions 610a and 610b of the antenna wire 610 may be loops (320a, 320b), as discussed above.

Prior to installing a chip (not shown, see 208, 308, 408) into the recess 606, a laser 630 (such as a UV laser) may be used to direct a beam of light 631 at the end portions 610a and 610b of the antenna wire 610, to remove insulating material (coating, such as enamel) therefrom, which may enhance subsequent bonding to terminals of the chip, and improve thermode ageing, as discussed hereinabove.

**FIG. 6B** illustrates a technique for repositioning wire bridges, such as discussed hereinabove with respect to **FIGs. 2A-2B**. A substrate 654 (compare 204) has a recess 656 (compare 206) extending through upper layers 654a (compare 104a) thereof, and slots 657a and 657b 656 (compare 207a and 207b) extending from opposite side edges of the recess 656 completely through the substrate 654, including bottom layers 654b (compare 104b) thereof. Wire bridges 660a and 660b (compare 210a and 210b) extend across the slots 657a and 657b.

After installing a chip 658 (compare 208) in the recess 656 (and after removing insulation from the wire bridges) a hook 640 (gripper tool, or multiple gripper tools, as described hereinabove) is used to grab the wire bridges and move them over to be atop corresponding ones of the terminals 658a and 658b of the chip 658.

In **FIG. 6B**, the hook 640 is shown getting ready to grab the wire bridge 660b, then drag it over to its new location (shown in dashed lines) atop the terminal 658b, for bonding thereto, as indicated by the arrow 642. The wire bridge 660a will be (or already is) similarly repositioned above the terminal 658a, for bonding thereto.

**FIG. 6C** shows a substrate 684 (compare 204, 304) with a recess 686 (compare 206, 306) having a transponder chip 688 (compare 208, 308) disposed in the recess 686. The transponder chip 688 has two terminal 688a and 688b (compare 208a/b, 308a/b). An antenna wire 690 (compare 210, 310) is mounted to the substrate 684. Two loops 690a and 690b (compare 320a/b) are formed in end portions (not separately designated, compare 310a, 310b) of the antenna wire (not separately designated, compare 320).

The loop 690a is shown standing up, pre-positioned, free-standing, in a vertical plane, in preparation for (prior to) being re-positioned to be atop the terminal 688a for connection (bonding) thereto. The loop 690b is shown dashed lines prior to being re-positioned atop the terminal 688b, and in solid lines re-positioned atop the terminal 912 for connection (bonding) thereto.

A simple mechanical tool 660, such as elongate member with a pushing end 662 may be urged against the free-standing loop to push it over onto (above, it need not be touching) the terminal of the substrate, as indicated by the arrow 664. The end 662 may be concave to "capture" the wire.

Alternatively, a "hook" type tool could be used to pull (rather than push) the wire to reposition it over the terminal. A hook type tool is shown in **FIG. 6B****.**

### Insulation Removal

Generally, insulated wire is preferred for the antenna coil because, for example, the wire may need to cross over itself (see "c", **FIG. 1A**). Although an insulated wire can be bonded to a terminal of a chip (or module), it is desirable to remove the insulation from the wire prior to interconnection (bonding to the terminal of the transponder chip) to ensure that no insulation residue is under the wire conductor at the bond site.

Conventionally, an insulated wire conductor (such as 210 or 319) is bonded to the terminal (such as 208a/b or 308a/b) of a chip (such as 208 or 308) using thermal (or thermo) compression bonding. This is a welding process in which the insulated wire conductor is bonded to the terminal of a chip by passing a current through a thermode, which holds the wire conductor under force against the terminal area of the chip. Typically, the first impulse of current removes the insulation, while the second impulse results in the diffusion of the wire conductor with the terminal area of the chip. To obtain a reasonable deformation of the wire conductor during the bonding process, a force between 1.8 and 2.5 Newton is required. However, the insulation between the wire conductor and the terminal of the chip may not have fully evaporated during the thermal compression bonding process, resulting in an unreliable interconnection. This quality issue may be resolved by removing the insulation before bonding.

One way to remove insulation before bonding would be to pass the wire conductor through a laser tunnel, before the wire conductor is mounted to the substrate. The laser tunnel can be driven by glass fiber connected to a multiplexing diode laser. The inner wall of the tunnel can be coated with a reflective material. The position of the insulation removal can be defined and the length of wire conductor which passes from the laser tunnel to the ultrasonic wire guide tool can be measured. By using an un-insulated wire at the bond position the force required for the diffusion process can be reduced, and better controlled. A 70 watt diode laser (808 nm) connected to a glass fiber (400 microns) can be used to remove a section of insulation layer (polyurethane) with a thickness of 2 to 4 microns from a moving wire conductor having a diameter of approximately 112 microns, by directing the laser beam to the side of the wire conductor under a gas atmospheric condition.

Alternatively, rather than removing insulation from the wire prior to mounting, an insulated wire can be mounted to the substrate, and the insulation from end portions of the insulated wire bridging the recess can be removed with a separate laser system. In such a case, it may be convenient, but it is not necessary, that the recess extends all the way through the substrate. In any case, it is believed to be preferable that the insulation (which may be used to help adhere the wire to the substrate, and to prevent short-circuiting at cross-overs such as "c" in **FIG. 1A**) is removed at portions (segments) of the end portions of the wire which will be bonded to the terminals of the transponder chip. The insulation can also be removed from loops (320a/b) which are pre-positioned on the substrate, adjacent a recess. To facilitate insulation removal, the recess (or slot extensions thereof, or separate slots adjacent the recess) can extend under the loops. Note that, in **FIG. 2A**, the slots 207a and 207b are under the wire-bridges of the end portions 210a, 210b of the wire 210 - in other words, under the portion of the free-standing loops whereat the insulation is removed.

When using a laser to remove insulation (non-conductive coating, typically enamel) from a wire conductor, in order to facilitate the interconnection of an insulated wire conductor to the terminal areas of an RFID chip, the enamel coating on the wire can be dyed with a dark color (such as black), to enhance absorption of the laser beam, hence heating (and evaporation) of the coating. A bare wire can also be blackened (the enamel is colored black) to increase the absorption of the laser beam, such as when performing interconnection of the wire to a terminal of a chip by laser welding. When using a laser to remove insulation, the wires can be attached to the terminals by conventional thermal compression bonding, or by laser welding, soldering, etc.

### A Manufacturing Flow

**FIG. 7** illustrates a manufacturing flow 700, showing a possible organization for the various manufacturing steps set forth hereinabove.

In a first step 702, a substrate is prepared. The substrate may have one or more (an array of) inlay sites. The substrate may be a multi-layer substrate, as discussed above. A given inlay site may have a recess (cavity, window) and may have slots, as described above. Substrates may be prepared well ahead of time, "off-line".

In a next step 704, and antenna wire is mounted to (embedded in, adhesively placed on) the substrate, as discussed above, leaving end portions of the wire un-mounted, and forming pre-positioned bridges or loops, as discussed hereinabove.

Two mounting procedures have been discussed hereinabove - (1) embedding the wire in the surface of the substrate, and (2) "adhesively positioning" a self-bonding wire to the surface of the substrate.

In a next step 706, which can be skipped if the wire is being embedded in rather than adhesively placed on the substrate, the self-bonding wire may be cured to the substrate, such as by using ultraviolet light, as discussed hereinabove.

In a next step 708, which can be skipped if the wire is not insulated, the insulation is removed from the looped (un-mounted) portions of the wire, as discussed hereinabove. If the wire is an insulated wire, the insulation can be removed either during mounting or after mounting, as discussed hereinabove.

As discussed hereinabove, there are generally two possibilities regarding chip installation - (1) the chip may have been installed on the substrate prior to mounting the wire and forming the loops (and, if necessary, curing and removing insulation from the wire), or (2) the chip may be installed on the substrate after mounting the wire and forming (pre-positioning) the loops.

In the process flow illustrated here, in a next step 710, the transponder chip is installed on the inlay substrate after mounting the wire and pre-positioning the end portions of the wire. Again, it should be understood that the substrate may be set up for a plurality of inlays, receiving a plurality of transponder chips, such as a 3 x 6 array of inlays.

One of ordinary skill in the art will readily understand how this, or other steps recited in this "fab flow" may be rearranged, recombined and/or omitted to suit particular circumstances.

Next, in a step 712, the bridges or loops are repositioned over terminals of the transponder chip, in preparation for connecting (bonding) the ends of the antenna wire(s) to the terminals of the chip, as discussed hereinabove. The antenna may be a single wire coil having two ends, or may be two wires forming a dipole, each of the dipole wires having one end for connecting to a terminal of the transponder chip, as discussed above.

Next in a step 714, the re-positioned bridges or loops of the antenna(s) are connected (bonded) to the terminals of the transponder chip.

Next, in a step 716, various post-processing steps may be performed, such as assembling the transponder inlay with additional layers of sheets in preparation for lamination

In a step 718, if there is a plurality of inlays on a common substrate, they may be singulated (separated) from the substrate.

In a step 720, various post-processing steps applicable to individual secure inlays may be performed.

Generally, each of the steps discussed hereinabove may be performed at a different station, or stations, in a manufacturing environment. This has various advantages, such as improved yields from the manufacturing process and greater throughput from the embedding machine with less operators.

While the invention has been described with respect to a limited number of embodiments, these should not be construed as limitations on the scope of the invention, but rather as examples of some of the embodiments. Those skilled in the art may envision other possible variations, modifications, and implementations that are also within the scope of the claims.

## Claims

1. Method of forming an inlay (200, 300) comprising an antenna wire (210, 310, 410) having two end portions (210a/b, 310a/b, 410a/b) and a site (206, 306) for a chip (208, 308, 408) with two terminals (208a/b, 308a/b, 408a/b, 658a/b, 688a/b), the site comprising two terminal areas (208a/b, 308a/b, 408a/b), the method comprising mounting the antenna wire to a surface of a substrate, **characterized by**:
leaving the end portions of the antenna wire un-mounted, as free-standing loops (220a/b, 320a/b) which are formed as generally upside-down U-shaped loops and which are pre-positioned adjacent the terminal areas;
and which are spaced apart from one another a distance which is greater than a corresponding width dimension of the chip;
installing a chip (208, 308, 408) which is an RFID or transponder chip or chip module at the site; and
repositioning the end portions of the antenna wire to be over corresponding terminals of the chip for bonding at least a portion of the free-standing loops to the terminals.

2. The method of claim 1, wherein mounting the antenna wire comprises:
embedding the antenna wire in the surface of the substrate or adhesively placing the antenna wire on the surface of the substrate.

3. The method of claim 1, wherein the free-standing loops are disposed in a plane which is substantially perpendicular to the surface of the substrate.

4. The method of claim 1, wherein the site comprise a recess (206, 306, 656, 686) in the substrate.

5. The method of claim 4, further comprising:
providing slots (207a/b) in the substrate, adjacent opposite sides of the recess.

6. The method of claim 4 or 5, wherein:
the end portions of the antenna wire span the recess or slots.

7. The method of claim 1, further comprising;
bonding the repositioned end portions of the antenna wire to the terminals.

8. The method of claims 1 or 7, wherein the antenna wire comprises a metallic wire covered by a coating of insulation, and further comprising:
removing the coating of insulation from at least a portion of the free-standing loops prior to bonding.

9. The method of claim 8, wherein:
removing the coating comprises using a laser (630), either during mounting the antenna wire or after mounting the antenna wire.

10. The method of claim 1, further comprising:
forming a first of the free-standing loops;
routing the wire conductor to form an antenna with a given number of turns of wire; and
forming a second of the free-standing loops.

11. The method of claim 10, wherein:
the loops are positioned and oriented so as not to interfere with subsequent installation of a chip, past the loops, at the transponder site.

12. The method of claim 1, further comprising:
at a point "a" on the surface of the substrate, commencing (502) mounting the antenna wire;
continuing to mount the antenna wire (504) a short distance to a point "b";
forming a first of the free-standing loops (506) in the wire, between the point "b" and a point "c", adjacent a first terminal area (208a, 308a, 408a) for the chip;
resuming mounting (508) from the point "c" through points "d" and "6`", to a point "f",
forming a second of the free-standing loops (514) in the wire, between the point "f" and a point "g", adjacent a second terminal area (208b, 308b, 408b) for the chip; and
continuing to mount the antenna wire (516) a short distance to a point "h", and at the point "h", and severing the wire.

13. The method of claim 1, wherein installing the chip comprises:
installing the chip at the site, past the end portions of the antenna wire.

14. An inlay substrate (204, 304) comprising a transponder site for a chip which is an RFID or transponder chip or chip module to be installed at the transponder site on the substrate and an antenna wire (210, 310) mounted to a surface of the substrate, **characterized in that**
end portions (210a/b, 310a/b) of the antenna wire (210, 310, 410) are left un-mounted as free-standing loops (220a/b, 320a/b) which are formed as generally upside-down U-shaped loops and which are pre-positioned adjacent the transponder site
and which are spaced apart from one another a distance which is greater than a corresponding width dimension of the chip so that the chip can be inserted onto the substrate from the same side of the substrate as the antenna, past the end portions of the wires, after the antenna has been mounted to the substrate, wherein:
the free-standing loops are jump loops (320a/b) disposed in a plane which is substantially perpendicular to the surface of the substrate.

## Patentansprüche

1. Verfahren zur Ausbildung eines Inlays (200, 300) umfassend einen Antennendraht (210, 310, 410) mit zwei Endbereichen (210a/b, 310a/b, 410a/b) und einen Einbauort (206, 306) für einen Chip (208, 308, 408) mit zwei Anschlüssen (208a/b, 308a/b, 408a/b, 658a/b, 688a/b), wobei der Einbauort zwei Anschlussbereiche (208a/b, 308a/b, 408a/b) umfasst, das Verfahren umfassend das Befestigen des Antennendrahts auf einer Oberfläche eines Substrates, **dadurch gekennzeichnet, dass**:
die Endbereiche des Antennendrahts unmontiert als freistehende Schlingen (220a/b, 320a/b),
die als allgemein kopfstehende U-förmige Schlingen ausgebildet sind und die angrenzend zu
den Anschlussbereichen vorpositioniert werden, belassen werden;
und welche voneinander in einem Abstand beabstandet sind, welcher größer als eine entsprechende Breitenabmessung des Chips ist;
an dem Einbauort ein Chip (208, 308, 408) eingesetzt wird, welcher ein RFID- oder
Transponderchip oder ein Chipmodul ist; und
die Endbereiche des Antennendrahts so neu positioniert werden, dass sie sich über entsprechenden Anschlüssen des Chips befmden, um mindestens einen Teil der freistehenden Schlingen mit den Anschlüssen zu bonden.

2. Verfahren nach Anspruch 1, wobei das Befestigen des Antennendrahts umfasst:
Einbetten des Antennendrahts in der Oberfläche des Substrats oder anhaftendes Platzieren des Antennendrahts auf der Oberfläche des Substrats.

3. Verfahren nach Anspruch 1, wobei die freistehenden Schlingen in einer Ebene, die im Wesentlichen senkrecht zur Oberfläche des Substrats liegt, angeordnet sind.

4. Verfahren nach Anspruch 1, wobei der Einbauort eine Ausnehmung (206, 306, 656, 686) im Substrat umfasst.

5. Verfahren nach Anspruch 4, weiterhin umfassend:
Bereitstellen von Aussparungen (207a/b) im Substrat, benachbart zu gegenüberliegenden Seiten der Ausnehmung.

6. Verfahren nach den Ansprüchen 4 oder 5, wobei:
die Endbereiche des Antennendrahts die Ausnehmung oder Aussparungen überspannen.

7. Verfahren nach Anspruch 1, weiterhin umfassend:
Bonden der neu positionierten Endbereiche des Antennendrahts mit den Anschlüssen.

8. Verfahren nach den Ansprüchen 1 oder 7, wobei der Antennendraht einen metallenen Draht umfasst, welcher von einer Isolierbeschichtung bedeckt ist, und weiterhin umfassend:
Entfernen der Isolierbeschichtung von mindestens einem Teilbereich der freistehenden Schlingen vor dem Bonden.

9. Verfahren nach Anspruch 8, wobei:
das Entfernen der Beschichtung die Verwendung eines Lasers (630) umfasst, entweder während der Befestigung des Antennendrahts oder nach Befestigung des Antennendrahts.

10. Verfahren nach Anspruch 1, weiterhin umfassend:
Ausbilden einer ersten der freistehenden Schlingen;
Führen der Verdrahtungsleitung, so dass eine Antenne mit einer vorbestimmten Anzahl von Drahtwindungen ausgebildet wird; und
Ausbilden einer zweiten der freistehenden Schlingen.

11. Verfahren nach Anspruch 10, wobei:
die Schlingen derart platziert und ausgerichtet sind, dass sie nicht das nachfolgende Einsetzen eines Chips, vorbei an den Schlingen, am Transpondereinbauort beeinträchtigen.

12. Verfahren nach Anspruch 1, weiterhin umfassend:
Beginnen (502) mit dem Befestigen des Antennendrahts an einem Punkt "a" auf der Oberfläche des Substrats;
Fortsetzen der Befestigung des Antennendrahts (504) über eine kurze Strecke zu einem Punkt "b";
Ausbilden einer ersten der freistehenden Schlingen (506) im Draht, zwischen dem Punkt "b" und
einem Punkt "c", angrenzend an einen ersten Anschlussbereich (208a, 308a, 408a) für den Chip;
Fortsetzen der Befestigung (508) von dem Punkt "c" durch Punkte "d" und "e" zu einem Punkt "f";
Ausbilden einer zweiten der freistehenden Schlingen (514) im Draht zwischen dem Punkt "f" und
einem Punkt "g", angrenzend an einen zweiten Anschlussbereich (208b, 308b, 408b) für den Chip;
und Fortsetzen der Befestigung des Antennendrahts (516) über eine kurze Strecke zu einem Punkt "h" und im Punkt "h", und Abtrennen des Drahts.

13. Verfahren nach Anspruch 1, wobei das Einsetzen des Chips umfasst:
Einsetzen des Chips am Einbauort, an den Endbereichen des Antennendrahts vorbei.

14. Inlaysubstrat (204, 304), umfassend einen Transpondereinbauort für einen Chip, welcher ein RFID- oder Transponderchip oder ein Chipmodul ist, der am Transpondereinbauort auf dem Substrat eingesetzt werden soll, und einen Antennendraht (210, 310), welcher auf einer Oberfläche des Substrats befestigt ist, **dadurch gekennzeichnet, dass**
Endbereiche (210a/b, 310a/b) des Antennendrahts (210, 310, 410) unmontiert als freistehende Schlingen (220a/b, 320a/b), die als allgemein kopfstehende U-förmige Schlingen ausgebildet sind und die angrenzend zu dem Transpondereinbauort vorpositioniert sind, belassen sind;
und welche in einem Abstand voneinander beabstandet sind, welcher größer als eine entsprechende Breitenabmessung des Chips ist, so dass der Chip auf das Substrat von der gleichen Seite des Substrats her wie die Antenne eingeführt werden kann, vorbei an den Endbereichen der Drähte, nachdem die Antenne auf dem Substrat befestigt worden ist, wobei:
die freistehenden Schlingen Sprungschlingen (320a/b) sind, die in einer Ebene, die im Wesentlichen senkrecht zur Oberfläche des Substrats liegt, angeordnet sind.

## Revendications

1. Procédé de formation d'un inlay (200, 300) comprenant un fil d'antenne (210, 310, 410) ayant deux portions d'extrémité (210a/b, 310 a/b, 410 a/b) et un emplacement (206, 306) pour une puce (208, 308, 408) avec deux terminaux (208a/b, 308a/b, 408a/b, 658a/b, 688a/b), l'emplacement comprenant deux zones de terminaux (208a/b, 308a/b, 408a/b), le procédé comprenant le montage du fil d'antenne à une surface d'un substrat, **caractérisé par**:
le fait de laisser les portions d'extrémité du fil d'antenne non montées comme des boucles libres (220a/b, 320a/b) qui sont formées comme des boucles généralement en forme d'U renversé et
qui sont pré-positionnées adjacentes aux zones de terminaux;
et qui sont espacées l'une de l'autre à une distance qui est supérieure à une dimension de largeur correspondante de la puce;
l'installation d'une puce (208, 308, 408) qui est une puce RFID ou une puce transpondeur ou un module de puce à l'emplacement et
le repositionnement des portions d'extrémité du fil d'antenne pour être au-dessus de terminaux correspondants de la puce pour l'interconnexion d'au moins une portion des boucles libres aux terminaux.

2. Procédé selon la revendication 1 dans lequel le montage du fil d'antenne comprend:
l'encastrement du fil d'antenne dans la surface du substrat ou le placement de manière adhésive du fil d'antenne sur la surface du substrat.

3. Procédé selon la revendication 1 dans lequel les boucles libres sont placées dans un plan qui est substantiellement perpendiculaire à la surface du substrat.

4. Procédé selon la revendication 1 dans lequel l'emplacement comprend un évidement (206, 306, 656, 686) dans le substrat.

5. Procédé selon la revendication 4 comprenant de plus:
le fait de prévoir des fentes (207a/b) dans le substrat, adjacentes aux côtés opposés de l'évidement.

6. Procédé selon la revendication 4 ou 5 dans lequel
les portions d'extrémité du fil d'antenne s'étendent au-dessus de l'évidement ou des fentes.

7. Procédé selon la revendication 1 comprenant de plus:
l'interconnexion des portions d'extrémité repositionnées du fil d'antenne aux terminaux.

8. Procédé selon la revendication 1 ou 7 dans lequel le fil d'antenne comprend un fil métallique couvert par une couche d'isolation et comprenant de plus:
l'enlèvement de la couche d'isolation d'au moins une portion des boucles libres avant l'interconnexion.

9. Procédé selon la revendication 8 dans lequel l'enlèvement de la couche comprend l'utilisation d'un laser (630), soit pendant le montage du fil d'antenne, soit après le montage du fil d'antenne.

10. Procédé selon la revendication 1 comprenant de plus:
la formation d'une première boucle libre des boucles libres;
le routage du conducteur du fil pour former une antenne avec un nombre donné de spires de fil; et
la formation d'une seconde boucle libre des boucles libres.

11. Procédé selon la revendication 10 dans lequel les boucles sont positionnées et orientées de manière à ne pas interférer avec l'installation ultérieure d'une puce, après les boucles, à l'emplacement du transpondeur.

12. Procédé selon la revendication 1 comprenant de plus:
à un point «a» sur la surface du substrat, le commencement (502) du montage du fil d'antenne;
la poursuite du montage du fil d'antenne (504) sur une petite distance jusqu'à un point «b»;
la formation d'une première boucle libre (506) des boucles libres dans le fil, entre le point «b» et
un point «c», adjacent à une première zone de terminaux (208a, 308a, 408a) pour la puce;
la reprise du montage (508) à partir du point «c» en passant par les points «d» et «e» jusqu'à un point «f»;
la formation d'une seconde boucle libre (514) des boucles libres dans le fil, entre le point «f» et
un point «g», adjacent à une seconde zone de terminaux (208b, 308b, 408b) pour la puce; et
la poursuite du montage du fil d'antenne (516) sur une petite distance jusqu'à un point «h», et au point «h», et le sectionnement du fil.

13. Procédé selon la revendication 1 dans lequel l'installation de la puce comprend l'installation de la puce à l'emplacement après les portions d'extrémité du fil d'antenne.

14. Substrat d'inlay (204, 304) comprenant un emplacement de transpondeur pour une puce qui est une puce RFID ou une puce transpondeur ou un module de puce qui doit être installé à l'emplacement du transpondeur sur le substrat et un fil d'antenne (210, 310) monté sur une surface du substrat, **caractérisé par**
des portions d'extrémité (210a/b, 310a/b) du fil d'antenne (210, 310, 410) sont laissées non montées comme boucles libres (220a/b, 320a/b) qui sont formées comme des boucles généralement en forme d'U renversé et qui sont pré-positionnées adjacentes à l'emplacement du transpondeur
et qui sont espacées l'une de l'autre à une distance qui est supérieure à une dimension de largeur correspondante de la puce si bien que la puce peut être insérée sur le substrat à partir du même côté du substrat que l'antenne, après les portions d'extrémité des fils, après que l'antenne ait été montée sur le substrat,
dans lequel les boucles libres sont des boucles de saut (320a/b) placées dans un plan qui est substantiellement perpendiculaire à la surface du substrat.
